# EUROPEAN PATENT APPLICATION

(11) **EP 2 309 823 A1**
(43) Date of publication of application: **13.04.2011**
(21) Application number: 09804818.4
(22) Date of filing: 15.06.2009
(51) Int. Cl.: H05B 33/10, H01L 21/02, H01L 21/336, H01L 21/363, H01L 27/12, H01L 29/786, H01L 51/05, H01L 51/40, H01L 51/50

(54) **METHOD FOR PRODUCING DEVICE**

(30) Priority: 05.08.2008 JP 2008201790
(71) Applicant: Toray Industries, Inc., Tokyo, 103-8666 (JP)
(72) Inventor: SHIRASAWA, Nobuhiko, Otsu-shi Shiga 520-8558 (JP); FUJIMORI, Shigeo, Otsu-shi Shiga 520-8558 (JP)
(74) Representative: Hager, Thomas Johannes
(86) International application number: PCT/JP2009/060825
(87) International publication number: WO 2010/016331

(57) **Abstract**

The present invention is directed to a method for producing a device, comprising the steps of: applying, on a donor substrate, a precursor material which is solvent-soluble during application and is capable of being converted to a device-constituting material after the application; converting the precursor material to a device-constituting material; and transferring the material on the donor substrate onto a device substrate.

According to the present invention, it is possible to produce an organic device that offers performance as high as that of an organic device produced by vapor deposition, and the present invention is particularly suitable for producing large-sized device.

## Description

### TECHNICAL FIELD

The present invention relates to a method for forming thin films constituting devices such as organic EL devices, organic thin film transistors (OFETs), photoelectric conversion devices, and various sensors and a method for producing a device using such a film-forming method.

### BACKGROUND ART

An organic device is a device having a structure in which an organic material is interposed between a cathode and an anode, and can achieve, for example, electroluminescence (organic EL device), current control (organic transistor), or photoelectric conversion (organic solar cell) by using an optimum organic material.

A method for producing such an organic device can be classified into a dry process typified by vacuum deposition and a wet process such as spin coating or ink-jet printing.

Vacuum deposition is a process used to form a film on a device substrate by sublimation of a small molecule material under vacuum. Such a process makes it possible to produce a device comprising a layered structure of two or more materials while the thickness of each film is arbitrarily controlled. All the above-mentioned devices, that is, organic EL devices, organic transistors, and organic solar cells can be produced by this process (see Non-Patent Documents 1 to 3). Particularly, organic EL devices produced by this process offer high performance in practical use.

However, vacuum deposition process has problems such as expensive manufacturing equipment, low utilization ratio of material and difficulty in producing large-area device by shadow-mask patterning method.

The wet process is advantageous in that the problems of the vacuum deposition process can be solved, that is, material utilization ratio can be improved and large-area devices requiring patterning can be easily produced (see Non-Patent Document 4). However, only materials having sufficient solubility in solvents suitable for the wet process can be used, and therefore the above-described small molecule materials are difficult to use without any chemical modifications in the wet process.

In order to solve such a problem, a technique for obtaining a material having desired properties by using a soluble precursor has been developed (see Patent Documents 1 to 4). More specifically, a soluble precursor is applied onto a device substrate to form a film, and is then converted to an organic semiconductor material by treatment (heating or light irradiation). Materials having low solubility can be applied to this technique as long as its precursor is soluble. However, this technique tends to deteriorate device characteristics because there is a problem that an underlayer is dissolved in a solvent and therefore it is difficult to produce a device having a layered structure. Further, there is a case where a solvent used for applying a precursor remains in trace amounts in a resultant device, which is a problem in that the efficiency and lifetime of the device are adversely affected.

### Prior Art Documents

### Patent Documents

- Patent Document 1:: JP-A-2003-304014
- Patent Document 2:: JP-A-2005-232136.
- Patent Document 3:: JP-A-2004-266157
- Patent Document 4:: JP-A-2008-135198

### Non-Patent Documents

Non-Patent Document 1: "Applied Physics Letters", Vol. 51, No. 12, pp. 913-915 (1987)
Non-Patent Document 2: "Chemistry of Materials", Vol. 16, No. 23, pp. 4824-4840 (2004)
Non-Patent Document 3: "Chemical Review", Vol. 107, No. 4, pp. 1233-1271 (2007)
Non-Patent Document 4: "2007 SID International Symposium DIGEST OF TECHNICAL PAPERS" pp. 1834-1837

### SUMMARY OF THE INVENTION

### PROBLEMS TO BE SOLVED BY THE INVENTION

As described above, highly-efficient devices having layered small molecule materials, especially highly-efficient organic EL devices are conventionally produced by vacuum deposition, but it is difficult to apply such a conventional technique to the production of large-sized panels.

In order to solve such a problem, it is an object of the present invention to provide a method for producing a device which is capable of producing a device having characteristics similar to those of a device produced by vapor deposition and which can be applied to the production of large-sized devices.

### MEANS FOR SOLVING THE PROBLEMS

The present invention is directed to a method for producing a device, comprising the steps of: applying, on a donor substrate, a precursor material which is solvent-soluble during application and is capable of being converted to a device-constituting material after the application; converting the precursor material to a device-constituting material; and transferring the material on the donor substrate onto a device substrate.

### EFFECTS OF THE INVENTION

According to the present invention, it is possible to produce an organic device that offers performance as high as that of an organic device produced by vapor deposition. Particularly, the method according to the present invention is suitable for producing large-sized organic EL displays.

### BRIEF DESCRIPTION OF THE DRAWINGS

Fig. 1 is a sectional view showing one example of a method for irradiating a donor substrate with light in the present invention.
Fig. 2 is a sectional view showing another example of the method for irradiating a donor substrate with light in the present invention.
Fig. 3 is a perspective view showing one example of a light-irradiation method used in the present invention.
Fig. 4 is a perspective view showing another example of the light-irradiation method used in the present invention.
Fig. 5 is a sectional view showing one example of an organic EL device having an emissive layer patterned according to the present invention.
Fig. 6 is a sectional view showing one example of a transfer step performed when an organic EL device is produced by the method according to the present invention.
Fig. 7 is a diagram showing one example of the shape of an ITO electrode formed on a glass substrate.

### BEST MODE FOR CARRYING OUT THE INVENTION

A method for producing a device according to the present invention comprises the steps of: (1) applying, onto a donor substrate, a precursor material which is solvent-soluble during application and is capable of being converted to a device-constituting material after the application; (2) converting the precursor material to a device-constituting material; and (3) transferring the material on the donor substrate onto a device substrate.

The present invention can be applied to a wet process because a material to be applied onto a donor substrate is a solvent-soluble precursor material. Therefore, even when a donor substrate having a large area is used, a device can be easily produced. Further, the precursor material is not directly applied onto a device substrate, and therefore a multilayered device can be produced without adverse effects such as elution of an underlayer during the application.

Further, the precursor material is converted to a device-constituting material and is transferred onto a device substrate. Therefore, even when an uneven coating of the material is occurred on the donor substrate, such an uneven coating is got rid of in the transfer step and an even device-constituting material layer is formed on a device substrate by transferring the material on the donor substrate.
Hereinbelow, the steps (1) to (3) will be described in order.

### (1) Step of applying, onto a donor substrate, a precursor material which is solvent-soluble during application and is capable of being converted to a device-constituting material after the application

The application step is a step in which a material to be transferred onto a device substrate is applied onto a donor substrate. Here, the donor substrate to be used in the present invention refers to a substrate on which a precursor material to be transferred onto a device substrate is applied to form a transfer layer. As the material to be transferred onto a device substrate, a precursor material is used which is solvent-soluble during application and is capable of being converted to a device-constituting material after the application. In general, many device-constituting materials are not solvent-soluble. However, in the present invention, a solvent-soluble precursor material of a device-constituting material is used, and therefore this step can be applied also to a case where a target device-constituting material is not solvent-soluble.

The precursor material which is solvent-soluble during application and is capable of being converted to a device-constituting material after the application refers to a material to which solvent solubility is improved by partially modifying the skeleton of a compound useful as a device-constituting material. For example, many compounds having a polyacene skeleton, such as anthracene, are poor in solvent solubility, but solvent solubility can be improved thereto by modifying a benzene ring in the polyacene skeleton in such a manner that a skeleton represented by, for example, any one of the following chemical formulas is formed. Therefore, a material obtained by modifying a compound, which has a polyacene skeleton and is useful as a device-constituting material, in such a manner as described above can be used as a precursor material.

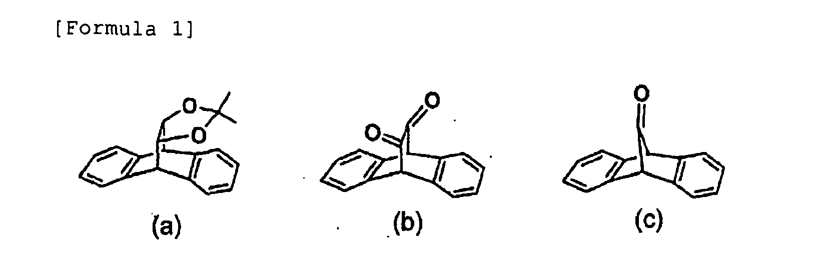

As will be described later with reference to the conversion step (2), there are, of course, also other precursor materials having such properties as described above. In the present invention, any compound can be used as long as its precursor material is solvent-soluble and is capable of being converted to a device-constituting material and the object of the present invention can be achieved by using a device-constituting material obtained by converting the precursor material.

Examples of a compound useful as a device-constituting material include compounds represented by the following chemical formulas.

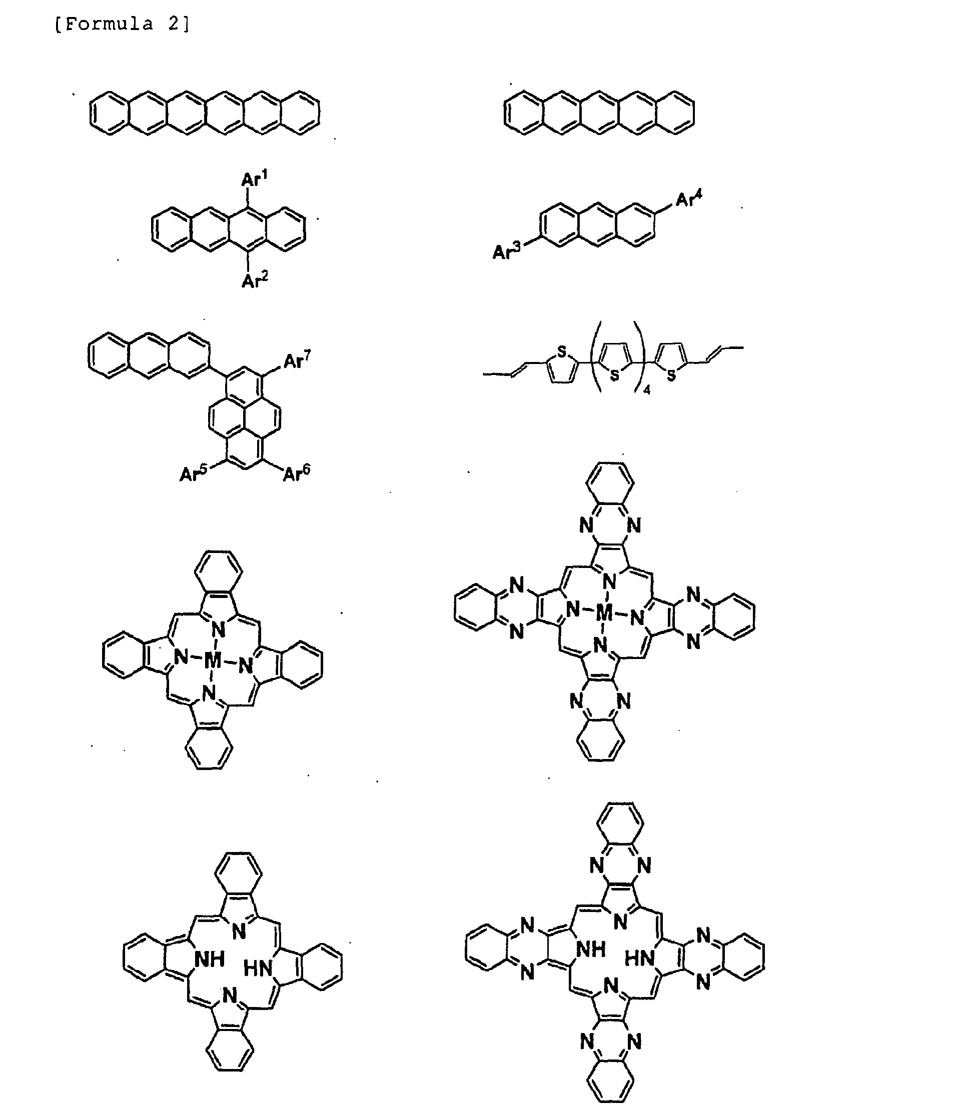

wherein Ar¹ to Ar⁷ each represent hydrogen, an aryl group, or a heteroaryl group, and may have a substituent. The substituent is preferably an aryl group or a heteroaryl group. In a case where Ar¹ to Ar⁷ are each an aryl group or a heteroaryl group, the number of carbon atoms of each of Ar¹ to Ar⁷, including the number of carbon atoms of its substituent (s), is preferably 1 to 20. Further, Ar¹ and Ar² may be the same or different from each other, Ar³ and Ar⁴ may be the same or different from each other, and Ar⁵ to Ar⁷ may be the same or different from one another. Further, M represents a metal ion. Specific examples of M include aluminum, gallium, indium, copper, zinc, iron, cobalt, nickel, rhodium, ruthenium, palladium, and platinum. A protonated compound obtained by replacing the metal ion with protons is also useful as a device-constituting material.

Among these device-constituting materials, those having a naphthacene skeleton, those having a pentacene skeleton, and those having an anthrylpyrene skeleton are particularly preferred because they are excellent as luminescence materials or organic semiconductors.

Examples of organic EL devices produced using the above-mentioned device-constituting materials include those disclosed in Japanese Patent No. 3196230, WO2007/097178, JP-A-2002-8867, and JP-A-2008-159778. Examples of organic transistors produced using the above-mentioned device-constituting materials include those disclosed in "Chemistry of Materials", Vol. 16, No. 23, pp. 4413-4422 (2004), "Chemical Review" Vol. 107, No. 4, pp. 1066-1096 (2007), and JP-A-2004-015007. Examples of organic solar cells produced using the above-mentioned device-constituting materials include those disclosed in JP-A-2004-055686, JP-A-2005-166744, and JP-A-2008-135622. The present invention can be applied to the production of devices which contain device constituting-materials disclosed in the above-mentioned documents by preparing solvent-soluble precursor materials of device-constituting materials disclosed in the above-mentioned documents.

In the present invention, the term "solvent solubility" refers to solubility in at least any one of the following solvents at room temperature under atmospheric pressure such that a solution having a concentration of 0.5 wt% or higher, preferably 1.0 wt% or higher, more preferably 3.0 wt% or higher can be prepared.

A solvent to be used in the present invention is not particularly limited, but is preferably capable of dissolving a precursor material to prepare a solution having the above-mentioned concentration and preferably has boiling point, viscosity, and surface tension which are suitable for an application process. Specific examples of such a solvent include, but are not limited to, water, alcohols having a boiling point of 100°C or higher and 250°C or lower (e.g., cyclohexanol, benzyl alcohol, octanol, trimethylhexanol, ethyleneglycol), chloroform, chlorobenzene, dichlorobenzene, trichlorobenzene, toluene, xylene, benzoates, tetralin (tetrahydronaphthalene), decalin (decahydronaphthalene), propionitrile, benzonitrile, acetophenone, cyclohexanone, phenol, γ-butyrolactone, N-methyl-2-pyrrolidone, and 1,3-dimethyl-2-imidazolidinone. Among these solvents, xylene, benzoates, tetralin, and cyclohexanone are preferably used. These solvents may be used in combination of two or more of them. Further, there is a fear that impurities contained in a solvent deteriorate the characteristics of a resultant device, and therefore a solvent having purity as high as possible is preferably used.

A solution for application can be prepared by stirring a precursor material and a solvent in a container. At this time, dissolution of the precursor material in the solvent can be promoted by heating or ultrasonication.

A donor substrate to be used in the present invention is not particularly limited as long as a precursor material can be applied thereto to form a transfer layer and the transfer layer can be transferred onto a device substrate. When it is necessary to perform patterning, a division pattern (bank) corresponding to a desired pattern may be provided on the donor substrate. Further, the donor substrate may be subjected to surface treatment so that a film can be properly formed when a precursor material is applied thereto or a film made of a material having physical properties necessary for transfer may be previously formed on the donor substrate. The surface treatment is intended to control the wettability of an application liquid, and is performed using, for example, a silane-based agent for hydrophilic treatment or a "Teflon®"-based agent for hydrophobic treatment. Examples of the material having physical properties necessary for transfer include heat insulating material, light-to-heat conversion materials, reflective materials, drying agents, polymerization initiators, polymerization inhibitors, and insulating materials.

Examples of a method for applying a precursor material include an ink-jet printing method, a spin coating method, a blade coating method, a slit-die coating method, a screen-printing method, a bar coater method, a casting method, a nozzle method, a print transfer method, a dipping method, and a spray method. Among them, an ink-jet printing method, a screen-printing method, a nozzle printing method, and a print transfer method are preferably used to produce devices requiring patterning such as organic EL devices and organic transistor devices.

The concentration of a precursor material in an application liquid is preferably adjusted to 1 to 5 wt%, more preferably 3 to 5 wt% by using the above-mentioned solvent.

The film thickness of a precursor material is not particularly limited as long as it is equal to or larger than a target thickness of a film made of a device-constituting material obtained by converting the precursor material, but is usually about 20 to 200 nm, preferably 10 to 100 nm, more preferably 20 to 50 nm. A thin film formed by applying a precursor material preferably has a uniform thickness and has no pinholes.

After a precursor material is applied onto a donor substrate, the donor substrate can be dried by allowing it to stand in an inert atmosphere under atmospheric pressure, but may be dried by allowing it to stand under a reduced pressure or under an inert gas flow to reduce the level of residual solvent. Alternatively, the donor substrate may be heated on a hot plate or in an inert oven, which is also effective at reducing the level of residual solvent. These techniques may be used in combination. When the donor substrate is heated, heating is preferably performed at a temperature as low as possible to prevent the thermal decomposition or thermal denaturation of the precursor material, and is therefore preferably performed under a reduced pressure. More specifically, the heating temperature is preferably 100°C or lower, more preferably 40 to 60°C.

### (2) Step of converting the precursor material to a device-constituting material

The conversion step is a step in which the structure of a precursor material is changed by, for example, heating, light irradiation, or contact with a reagent to convert the precursor material to a target device-constituting material. In this case, a factor causing a change in structure is preferably, for example, heat, light, or a volatile compound which does not remain in a target device-constituting material to prevent deterioration of characteristics of a resultant device. The volatile compound refers to an acid or an alkali, which leaves no residues, such as hydrochloric acid-ether complex or ammonia gas. Among changes in structure caused by such factors, those caused by light irradiation and/or heating are particularly preferred. When a change in structure is caused by heating, the heating temperature is preferably as low as possible to prevent the deterioration of a material obtained by converting a precursor material. For this reason, a precursor material which can be converted to a device-constituting material at 180°C or lower is preferably used. As will be described later, the structure of a precursor material is changed by, for example, elimination of a small molecule such as ethylene, carbon monoxide, or carbon dioxide from the precursor material. Among precursor materials whose structure is changed by elimination of a small molecule therefrom, those whose structure is changed by elimination of ethylene or carbon monoxide are preferred because they can be converted to a device-constituting material at 180°C or lower. The heating can be performed using, for example, a hot plate, an inert oven, or an infrared heater.

On the other hand, when a change in structure is caused by light irradiation, visible light is preferably used. This is because there is a case where an undesired reaction is caused by UV light (i.e. , by light having wavelengths shorter than 390 nm) depending on the type of precursor material used. Therefore, in the case that an undesired reaction does not occur, for example, white light may be used as it is for light irradiation. However, in the case that an undesired reaction occurs, light containing little or no UV light is preferably used for light irradiation. In this case, a precursor material is preferably irradiated with light obtained by, for example, allowing light emitted from a light source to pass through a UV cut filter.

A more preferred wavelength of irradiation light depends on the type of precursor material used. However, as will be described later, when a precursor material converted to a device-constituting material with generation of carbon monoxide (a precursor material having a keto-bridged structure and/or a diketo-bridged structure) is used, blue light is particularly preferably used to achieve efficient conversion to a device-constituting material. More specifically, light having a peak wavelength of 430 to 470 nm and a peak half-width of 50 nm or less is preferably used. A compound converted to a device-constituting material with generation of carbon monoxide shows absorption resulting from n-π* transition of a carbonyl group in the wavelength range. This absorption does not depend heavily on the structure of the compound. The conversion reaction from a precursor material to a device-constituting material involving generation of carbon monoxide proceeds due to excitation of the precursor material by absorption of light having a peak wavelength of 430 to 470 nm and a peak half-width of 50 nm or less, and therefore the precursor material is particularly preferably irradiated with such light.

As a light source to be used for light irradiation, a high intensity lamp and a band-pass filter may be used together or a light-emitting diode may be used. Examples of such a high intensity lamp include, but are not limited to, a high-pressure mercury lamp, a halogen lamp, and a metal halide lamp. Among them, a light-emitting diode is preferably used because only light having a target wavelength can be obtained for light irradiation. The conversion step may be performed by a combination of light irradiation and heating of a donor substrate. This has the effect of shortening treatment time due to the promotion of conversion caused by light irradiation. The heating temperature is preferably 150°C or lower, more preferably 40 to 100°C.

When a change in structure is caused by contact with a reagent, for example, a substrate may be immersed in a reagent contained in a storage tank or a reagent may be sprayed onto a substrate. In either case, conversion may be promoted by heating the substrate after contact with a reagent. Further, the step of removing the reagent by washing may be performed after the completion of conversion.

Specific examples of the conversion reaction include Retro Diels-Alder reaction, cheletropic reaction, decarboxylation reaction, ester decomposition reaction, and decarbonylation of carbonyl compounds.

Specific examples of a change in structure are represented by the following reaction formulas. Each of the following formulas indicates that a compound obtained by previously converting a compound, which is a device-constituting material having a skeleton shown on the right side of the arrow, so that a solvent-soluble skeleton shown on the left side of the arrow is formed is used as a precursor material in the present invention. It is to be noted that these changes in structure are merely examples, and a change in structure according to the present invention is not limited thereto.

Examples of a change in structure caused by heating are as follows.

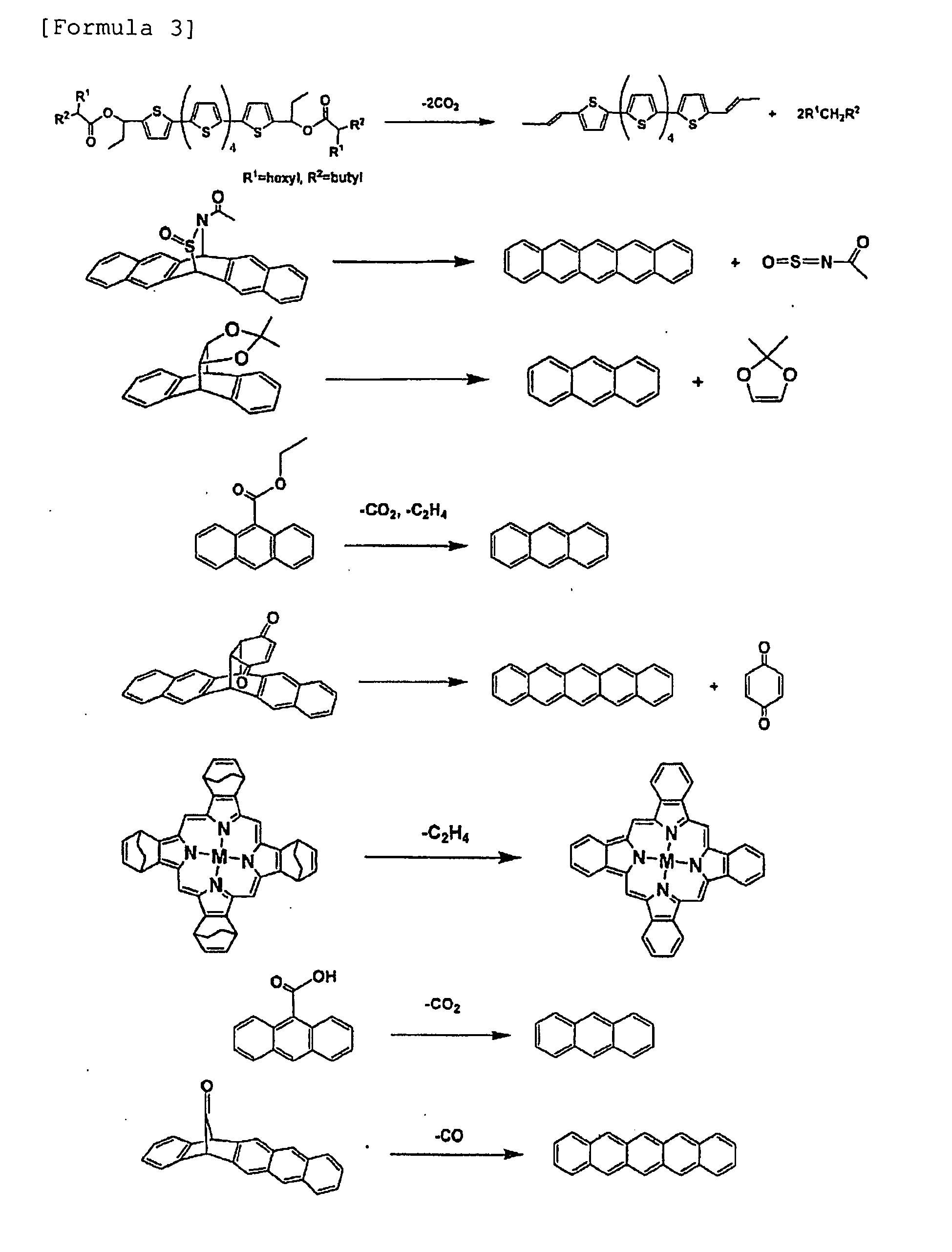

wherein M represents aluminum, gallium, indium, copper, zinc, iron, cobalt, nickel, rhodium, ruthenium, palladium, platinum, or the like.

Examples of a change in structure caused by light are as follows.

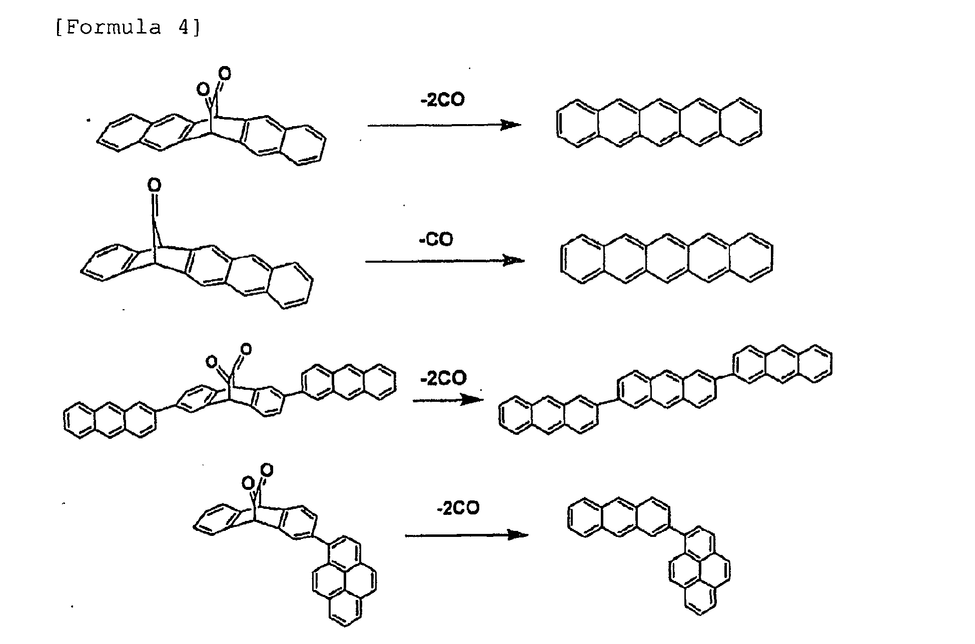

Examples of a method for synthesizing a precursor material include a method for synthesizing a target precursor material by Diels-Alder reaction using a device-constituting material and a method for chemically synthesizing a precursor material from raw materials other than a device-constituting material. More specifically, a precursor material can be synthesized by a method disclosed in, for example, JP-A-2003-304014, JP-A-2004-266157, JP-A-2005-232136, or "Tetrahedron Letters", Vol. 46, pp. 1981-1983 (2005).

The conversion step is preferably performed under an inert atmosphere to avoid contact with moisture/oxygen causing deterioration of a material obtained by converting a precursor material or degradation of device characteristics as much as possible. The inert atmosphere is provided by, for example, a noble gas such as argon, helium, or xenon, nitrogen, or carbon dioxide. Among them, argon, helium, or nitrogen is preferred, and argon or nitrogen is more preferred. As described above, the type of reaction of a precursor material used in the present invention is not particularly limited. However, a precursor material converted to a device-constituting material with generation of carbon monoxide (a precursor material having a keto-bridged structure and/or a diketo-bridged structure) is preferably used because a trace amount of moisture or oxygen present on a donor substrate can be removed. More specifically, carbon monoxide generated in a thin film reacts with water or oxygen present in the thin film by heating and/or light irradiation so that hydrogen or carbon dioxide is generated, and as a result, water or oxygen is removed.

The term "keto-bridged structure" used herein refers to a structure having a bicyclo skeleton having a bridging carbonyl group such as one represented by the chemical formula 1(c). The term "diketo-bridged structure" used herein refers to a structure having an α-diketo-bridged bicyclo skeleton such as one represented by the chemical formula 1(b).

Examples of a compound useful as such a precursor material converted to a device-constituting material with generation of carbon monoxide are as follows.

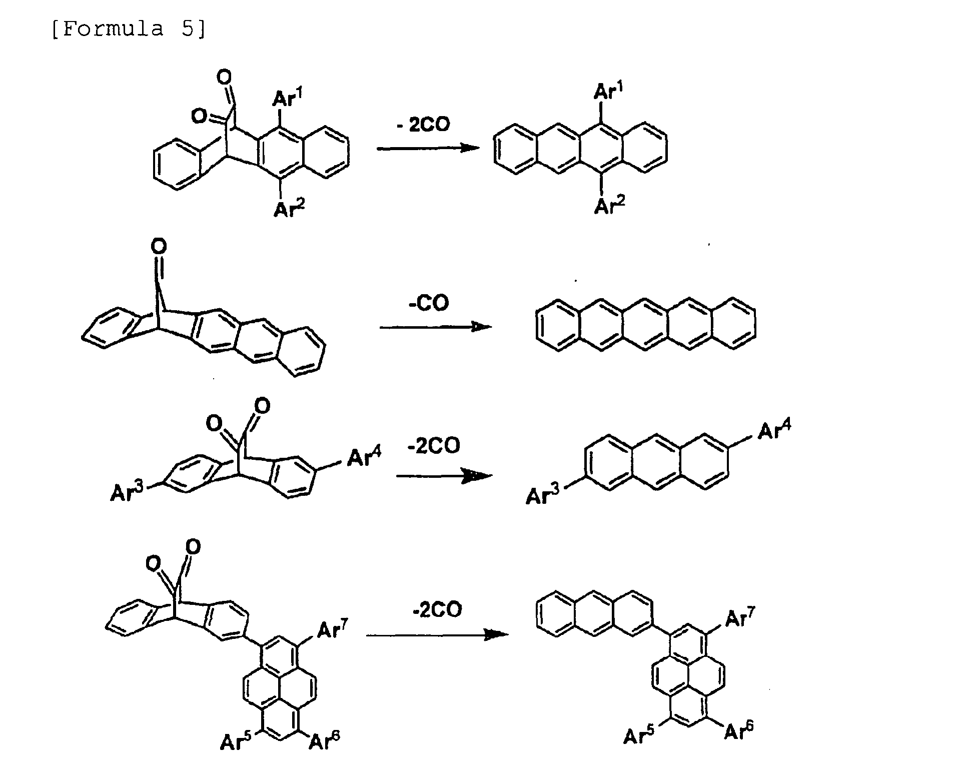

wherein Ar¹ to Ar⁷ each represent hydrogen, an aryl group, or a heteroaryl group, and may be substituted or unsubstituted. Ar¹ to Ar⁷ may be the same or different from one another. When Ar¹ to Ar⁷ are each an aryl group or a heteroaryl group, the number of carbon atoms of each of Ar¹ to Ar⁷, including the number of carbon atoms of its substituent(s), is preferably 1 to 20. Specific examples of such Ar¹ to Ar⁷ include those disclosed in WO2007/097178 and Japanese Patent No. 3712760.

### (3) Step of transferring the material on the donor substrate onto a device substrate

The transfer step is a step in which a device substrate and a donor substrate are stacked together to transfer a material on the donor substrate onto the device substrate by, for example, heating or light irradiation. The device substrate and the donor substrate can be stacked together by a well-known method. In order to improve transfer efficiency, a space between the donor substrate and the device substrate is preferably under vacuum or under a reduced-pressure atmosphere of 0.01 Torr or less. However, if necessary, the space may be under an inert atmosphere. The formation of a bank made of an insulating material on the donor substrate is useful to produce a vacuum or a reduced-pressure atmosphere in the space between the donor substrate and the device substrate because adhesion between these substrates can be improved.

The transfer step can be performed by a well-known method such as a method in which a donor substrate and a device substrate stacked together are heated from the donor substrate side or a method in which a donor substrate and a device substrate stacked together are irradiated with light from the donor substrate side. The heating can be performed using, for example, a hot plate or an infrared heater. In a case where the donor substrate has a light-to-heat conversion layer formed thereon, the same effect as heating can be obtained by irradiating the light-to-heat conversion layer with light having an appropriate wavelength, which makes it possible to perform transfer. In this case, irradiation light is preferably laser light because its center wavelength and irradiation intensity and an area to be irradiated can be appropriately selected. The transfer by irradiation with laser light may be completed by performing irradiation once or by performing irradiation two or more times. Further, the transfer by irradiation with laser light may be performed by scanned irradiation, stepwise irradiation, or full area irradiation. As described above, in the transfer step, the material on the donor substrate is heated, sublimated, and finally transferred onto the device substrate. Therefore, it is possible to form a uniform film similar to that obtained by vapor deposition and therefore to obtain a high-performance device.

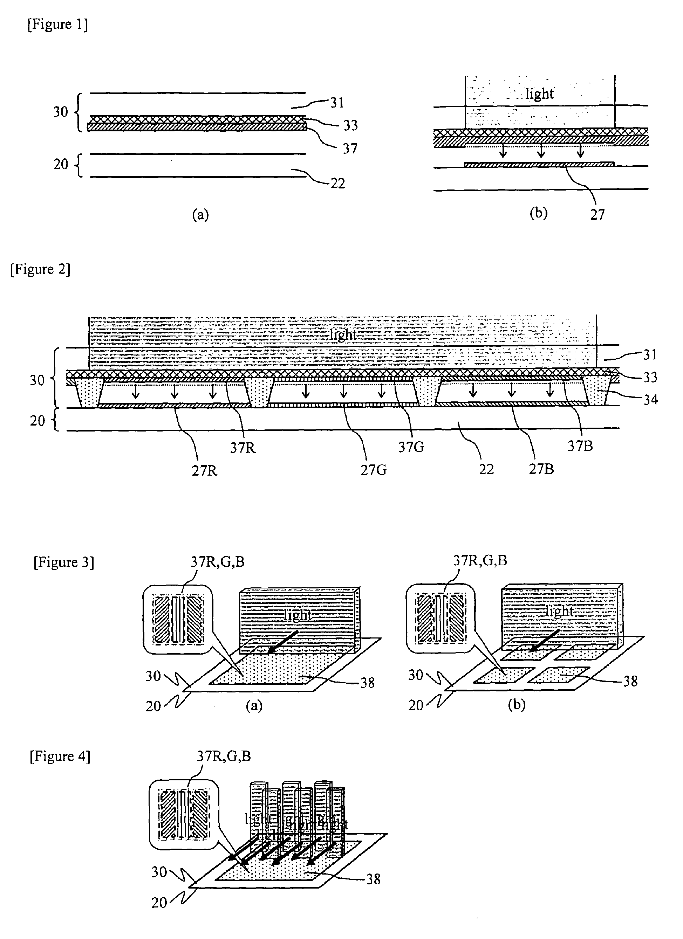

Examples of the transfer step will be described with reference to Figs. 1 and 2, but are not intended to limit the present invention. Fig. 1 is a sectional view showing one example of a method for irradiating a donor substrate with light in the present invention. As shown in Fig. 1(a), a donor substrate 30 comprises a support 31, a light-to-heat conversion layer 33, and one type of device-constituting material 37, and a transfer substrate 20 comprises only a support 22. As shown in Fig. 1(b), light typified by laser light is allowed to enter the donor substrate 30 from the support 31 side to irradiate the light-to-heat conversion layer 33 with light so that a part of the device-constituting material 37 is heated, and as a result, the device-constituting material 37 is transferred onto the transfer substrate.

Fig. 1(b) schematically shows a process in which the device-constituting material 37 is evaporated by heating and deposited on the support 22 of the device substrate 20 as a transferred layer 27. At this point of time, light irradiation may be stopped (irradiation of this area with light may be stopped to irradiate another area with light). Alternatively, light irradiation may be continued until the device-constituting material 37 is completely transferred. In the present invention, ablation mode can be employed by appropriately selecting the type of device-constituting material or the conditions of light irradiation, in which the device-constituting material 37 reaches the support 22 of the device substrate 20 while being maintained in a film state. However, from the viewpoint of reducing damage to a device-constituting material, transfer is preferably performed in deposition mode in which the device-constituting material 37 is evaporated and transferred in a state where it is broken down into individual molecules (atoms) or clusters of up to 100 molecules (atoms).

In the present invention, transfer is particularly preferably performed by repeatedly irradiating the light-to-heat conversion layer 33 with light two or more times per donor substrate 30 so that the device-constituting material 37 is transferred in two or more steps in its thickness direction. This makes it possible to decrease the maximum achieving temperature of not only the device-constituting material 37 but also an underlayer which was formed on the device substrate 20, thereby preventing damage to the donor substrate or degradation of the performance of a resultant device. When the device-constituting material 37 is transferred in two or more steps, the number of steps n is not particularly limited, but is preferably 5 or more but 50 or less. If the number of steps n is too small, the above-described effect of decreasing temperature cannot be sufficiently obtained. On the other hand, if the number of steps n is too large, adverse effects are caused by a prolonged cumulative heating time.

Fig. 2 shows one preferred embodiment of the present invention in which batch transfer of two or more different types of device-constituting materials 37 (in this case, three types of device-constituting materials 37R, 37G, and 37B) is performed by irradiating the light-to-heat conversion layer 33 with light wider than the total width of the two or more different types of device-constituting materials 37 (in this case, three types of device-constituting materials 37R, 37G, and 37B) and a width of a division pattern 34 (in this case, widths of two of division patterns 34 provided between the 37R and the 37G and between the 37G and the 37B). By providing the division pattern 34, it is possible to suppress mixing of the 37R, 37G, and 37B with one another when the 37R, 37G, and 37B are transferred. Herein, batch transfer of a set of the 37R, 37B, and 37B is illustrated by way of example. However, as is often the case with displays, when a set of the transferring materials 37R, 37G, and 37B is repeatedly formed k times in an x direction (i. e. , in a direction in which the 37R, 37G, and 37B are arranged) and h times in a y direction perpendicular to the x direction, for example, m (m is an integer of 2 or more and k or less) sets of the transferring materials 37R, 37G, and 37B may be simultaneously irradiated with light while light is scanned in the y direction. In this case, a transfer time can be reduced to about 1/m.

In a case where m=k, as shown in Fig. 3 (a), batch transfer of the whole transferring material can be performed by one-time scanning of a transfer area 38 of the donor substrate 30 with light covering the entire width of the transfer area 38. In the case of this arrangement, alignment of irradiation light with respect to the donor substrate 30 is significantly facilitated. As shown in Fig. 3(b), also in a case where a plurality of the transfer areas 38 are present on the substrate, batch transfer of them can be performed. Even in the case of so-called delta alignment in which R, G, and B subpixels are not arranged in line, transfer of the transferring materials can be easily performed because irradiation light can be linearly scanned.

As shown in Fig. 4, the transferring material layer 37 can be transferred also by simultaneously scanning a plurality of light beams arranged in a staggered configuration in a scanning direction. This makes it possible, even when it is difficult to obtain a single light beam covering the entire width of the transfer area 38 due to limitations of maximum output or light uniformity of a light source, to perform pseudo-batch transfer of the whole transferring material as in the case of one-time scanning (m=k).

According to a preferred embodiment of the production method of the present invention, the conversion step (2) is performed before the transfer step (3) (method I) or the conversion step (2) and the transfer step (3) are simultaneously performed (method II). In the case of the method I, after a precursor material is applied onto a donor substrate, the precursor material is converted to a device-constituting material by the above-described method and then transferred onto a device substrate. In the case of the method II, after a precursor material is applied onto a donor substrate, the donor substrate and a device substrate are stacked together, and the precursor material is transferred onto the device substrate by, for example, heating or light irradiation while converted to a device-constituting material by utilizing energy generated by heating or light irradiation for transfer. In a case where the transfer is performed using near-infrared laser light, the precursor material may be irradiated with both laser light for transfer and light for conversion at the same time. However, the method I is more preferred because conversion from a precursor material to a device-constituting material is uniformly performed at a high conversion ratio.

Hereinbelow, production of a device by the method according to the present invention will be described with reference to production of an organic EL device for which the method according to the present invention particularly useful.

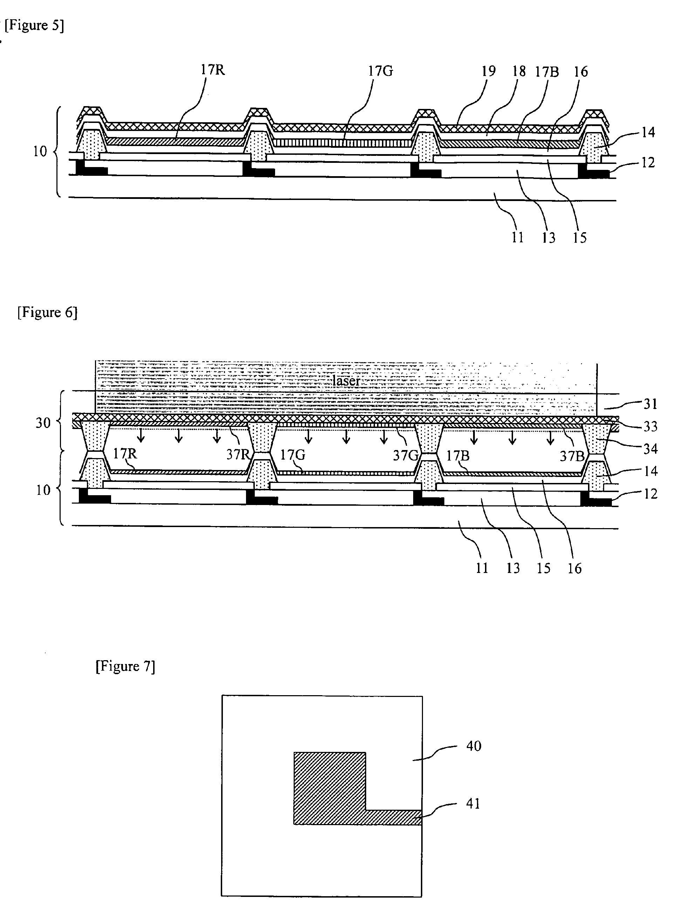

Fig. 5 is a sectional view showing a typical example of the structure of an organic EL device 10 (display). An active-matrix circuit comprising a TFT 12 and a planarizing layer 13 is formed on a support 11. A device portion of the organic EL device 10 is formed on the active-matrix circuit and comprises a first electrode 15, a hole-transporting layer 16, an emissive layer 17, an electron-transporting layer 18, and a second electrode 19. An insulating layer 14 defining light-emitting regions is formed at the ends of first electrodes to prevent short circuit at electrode ends. The structure of the device is not limited to this example. For example, only one emissive layer having both hole-transporting function and electron-transporting function may be provided between the first electrode and the second electrode, or the hole-transporting layer may have a laminated structure comprising a hole-injection layer and a hole-transporting layer and the electron-transporting layer may have a laminated structure comprising an electron-transporting layer and an electron-injection layer, or the electron-transporting layer may be omitted when the emissive layer has electron-transporting function. Further, the device may be formed by laminating a first electrode, an electron-transporting layer, an emissive layer, a hole-transporting layer, and a second electrode in this order. Each of these layers may be composed of a single layer or two or more layers. It is to be noted that although not shown in Fig. 5, formation of a protective layer or a color filter or sealing may be performed by a well-known technique after the second electrode is formed.

In a case where the organic EL device 10 is a color display, at least the emissive layer needs to be patterned. The method according to the present invention is suitable for patterning a thin film serving as the emissive layer. The insulating layer, the first electrode, and the TFT are often patterned by well-known photolithography, but may be patterned by the method according to the present invention. Further, in a case where at least one of the hole-transporting layer, the electron-transporting layer, and the second electrode needs to be patterned, the method according to the present invention may be used for patterning. Further, among the emissive layers R, G, and B, only the emissive layer R and the emissive layer G may be patterned by the method according to the present invention. In this case, a layer serving as both an emissive layer B and an electron-transporting layer for R and G may be formed on the entire surface of the emissive layers R and G.

The organic EL device shown in Fig. 5 is produced, for example, in the following manner. Layers up to the first electrode 15 are formed by photolithography, and then the insulating layer 14 is patterned by a well-known technique using a photosensitive polyimide precursor material, and then the hole-transporting layer 16 is formed by a well-known technique utilizing vapor deposition on the entire surface. Then, the emissive layers 17R, 17G, and 17B are patterned on the hole-transporting layer 16 through the above-described steps (1) to (3). Then, the electron-transporting layer 18 and the second electrode 19 are formed on the entire surface of the emissive layers 17R, 17G, and 17B by a well-known technique such as vapor deposition. In this way, the organic EL device is completed.

Fig. 6 is a sectional view showing one example of the transfer step performed in the production of the organic EL device. As shown in Fig. 6, the donor substrate 30 comprises the support 31, the light-to-heat conversion layer 33, the division pattern 34, and the luminescence materials 37R, 37G, and 37B (each of which is obtained by applying a precursor material of an organic EL material of R, G, or B and changing the skeleton thereof) present in the division pattern. The donor substrate 30 and the device substrate 10 are opposed to each other so that the division pattern 34 of the donor substrate 30 is aligned with the insulating layer 14 of the device substrate 10. The donor substrate 30 is irradiated with laser light from the support 31 side so that the light-to-heat conversion layer 33 absorbs the laser light, and at the same time, the luminescence materials 37R, 37G, and 37B are heated and evaporated by heat generated in the heat-to-light conversion layer 33. As a result, the luminescence materials 37R, 37G, and 37B are deposited on the hole-transporting layer 16 of the device substrate 10 so that the emissive layers 17R, 17G, and 17B are formed by one operation.

The emissive layer may be composed of a single layer or two or more layers, and each layer constituting the emissive layer may be made of a single luminescence material or a mixture of two or more luminescence materials. From the viewpoint of luminance efficiency, color purity, and durability, the emissive layer preferably has a structure comprising a single layer made of a mixture of a host material and a dopant material. Therefore, a transferring material for forming a film serving as the emissive layer is preferably a mixture of a host material and a dopant material. In this case, a material to be converted to a host material is preferably used as a precursor material, and the emissive layer can be formed by applying a mixed solution of such a precursor material and a dopant material onto a donor substrate, drying the mixed solution, and performing the conversion step and the transfer step.

It is to be noted that a solution of the precursor material and a solution of the dopant material may be separately applied onto a donor substrate. The precursor material or the host material and the dopant material do not need to be homogeneously mixed on the donor substrate as long as they are homogeneously mixed at the time when transferred onto the organic EL device. Further, the concentration of the dopant material in the emissive layer may be changed in a thickness direction at the time of transfer by utilizing a difference in sublimation temperature between the precursor material or the host material and the dopant material. Examples of luminescence materials (a device-constituting material obtained by converting the above-described precursor material and a dopant material) include: small molecule materials such as anthracene derivatives, naphthacence derivatives, pyrene derivatives, various metal complexes such as quinolinol complexes (e.g., tris (8-quinolinolato) aluminum (Alq₃)) and zinc benzothiazolyl phenol complex, bis(styryl)anthracene derivatives, tetraphenylbutadiene derivatives, coumarin derivatives, oxadiazole derivatives, benzoxazole derivatives, carbazole derivatives, distyrylbenzene derivatives, pyrrolopyridine derivatives, perinone derivatives, cyclopentadiene derivatives, oxadiazole derivatives, thiadiazopyridine derivatives, rubrene, quinacridone derivatives, phenoxazone derivatives, perinone derivatives, perylene derivatives, coumarin derivatives, chrysene derivatives, pyrromethene derivatives, and iridium complex-based materials called phosphorescent materials; and polymer materials such as polyphenylene vinylene derivatives, poly(para-phenylene) derivatives, and polythiophene derivatives. Among them, anthracene derivatives, naphthacene derivatives, pyrene derivatives, chrysene derivatives, pyrromethene derivatives, and various phosphorescent materials are excellent in light-emitting performance and are therefore particularly suitable for carrying out the method according to the present invention.

The hole-transporting layer may be composed of a single layer or two or more layers, and each layer constituting the hole-transporting layer may be made of a single material or a mixture of two or more materials. The hole-transporting layer also includes a layer called "hole-injection layer". From the viewpoint of hole-transporting ability (low drive voltage) and durability, the hole-transporting layer may contain an acceptor material that promotes its hole-transporting ability. Therefore, a transferring material for forming a film serving as the hole-transporting layer may be made of a single material or a mixture of two or more materials.

Examples of a hole-transporting material include: small molecule materials such as aromatic amines typified by N,N'-diphenyl-N,N'-dinaphthyl-1,1'-diphenyl-4,4'-diamine (NPD), N,N'-biphenyl-N,N'-biphenyl-l,l'-diphenyl-4,4'-diamine, and N,N'-diphenyl-N,N'-(N-phenylcarbazolyl)-1,1'-dipheyl-4,4'-d iamine and heterocyclic compounds typified by N-isopropyl carbazole, pyrazoline derivatives, stilbene-based compounds, hydrazone-based compounds, oxaziazole derivatives, and phthalocyanine derivatives; and polymer materials such as polycarbonates, styrene derivatives, polyvinyl carbazoles, and polysilanes having these low-molecular compounds as side chains. Examples of an acceptor material include small molecule materials such as 7,7,8,8-tetracyanoquinodimethane (TCNQ), hexaazatriphenylene (HAT), and its cyano-group derivatives (HAT-CN6). Further, a metal oxide, such as molybdenum oxide or silicon oxide, formed on the surface of the first electrode in the form of a thin film can be mentioned as an example of the hole-transporting material or the acceptor material.

The electron-transporting layer may be composed of a single layer or two or more layers, and each layer constituting the electron-transporting layer may be made of a single material or a mixture of two or more materials. The electron-transporting layer also includes a layer called "hole-blocking layer" or "electron-injection layer". From the viewpoints of electron-transporting ability (low drive voltage) and durability, the electron-transporting layer may contain a donor material that promotes its electron-transporting ability. A layer called "electron-injection layer" is often discussed as the donor material. A transferring material for forming a film serving as the electron-transporting layer may be made of a single material or a mixture of two or more materials.

Examples of an electron-transporting material include: small molecule materials such as quinolinol complexes (e.g., Alq₃ and 8-quinolinolato lithium (Liq)), condensed polycyclic aromatic derivatives (e.g., naphthalene and anthracene), styryl-based aromatic ring derivatives typified by 4,4'-bis(diphenylethenyl)biphenyl, quinone derivatives (e.g., anthraquinone and diphenoquinone), phosphorus oxide derivatives, benzoquinolinol complexes, hydroxyazole complexes, azomethine complexes, various metal complexes (e.g., tropolone metal complexes and flavonol metal complexes), and compounds having a heteroaryl ring structure containing electron-accepting nitrogen; and polymer materials having these small molecular compounds as side chains.
Examples of a donor material include: alkali metals and alkaline-earth metals such as lithium, cesium, magnesium, and calcium; various metal complexes such as quinolinol complexes thereof; and oxides and fluorides thereof such as lithium fluoride and cesium oxide. The electron-transporting material or the donor material is one of materials which can easily change the performance of a light-emitting device when used in combination with each of the emissive layers R, G, and B, and is therefore another preferred example to be patterned by the method according to the present invention. At least one of the first electrode and the second electrode is preferably transparent in order to extract light emitted from the emissive layer. In the case of a bottom emission structure in which light is extracted from the first electrode side, the first electrode is transparent, and in the case of a top emission structure in which light is extracted from the second electrode side, the second electrode is transparent. Further, reactive transfer may be performed by, for example, reacting a transferring material with oxygen during transfer. Examples of materials for forming a transparent electrode and the other electrode include well-known materials disclosed in, for example, JP-A-11-214154.

An organic EL device produced by the method according to the present invention is not limited to an active matrix-type organic EL device in which a second electrode is generally formed as a common electrode, and may be, for example, a passive matrix-type organic EL device in which a stripe-like first electrode intersects with a stripe-like second electrode or a segment-type organic EL device in which a display section is patterned to display predetermined information. These various types of organic EL devices can be used for, for example, TV sets, personal computers, monitors, watches, thermometers, audio instruments, and display panels for cars.

Further, an organic EL device produced by the method according to the present invention offers performance as high as that of an organic EL device produced by vapor deposition, and is therefore excellent in luminance efficiency and device lifetime. Although a large-sized organic EL device is difficult to produce by vapor deposition, the method according to the present invention is capable of producing a large-sized organic EL device excellent in luminance efficiency and device lifetime.

The method for producing a device according to the present invention can be applied not only to the production of organic EL devices but also to the production of other devices such as organic TFTs, photoelectric conversion devices, and various sensors. For example, when the method according to the present invention is applied to the production of a typical organic TFT comprising a source electrode, a drain electrode, an organic semiconductor layer formed therebetween, a gate insulating layer, and a gate electrode, such an organic TFT is produced, for example, in the following manner. First, a gate electrode, a gate insulating layer, a source electrode, and a drain electrode are formed on a substrate by a well-known method to prepare a device substrate. On the other hand, a solvent-soluble precursor material of a material for forming an organic semiconductor layer is dissolved in an appropriate solvent to obtain a solution, and then the solution is applied onto another substrate to prepare a donor substrate. Then, according to the method of the present invention, the precursor material is converted to an organic semiconductor layer-forming material, and then the donor substrate and the device substrate are opposed to each other to transfer the organic semiconductor layer-forming material onto a predetermined position on the device substrate. Then, if necessary, a sealing film is formed by a well-known method or the method according to the present invention. In this way, the organic TFT is produced. It is to be noted that materials for forming the substrates, the source electrode, the drain electrode, the gate insulating layer, and the gate electrode are not particularly limited, and well-known materials such as materials disclosed in, for example, JP-A-2006-173444 can be used.

### Examples

Hereinbelow, the present invention will be described with reference to the following examples, but is not limited to these examples.

¹H-NMR was recorded on Superconductive FT-NMR EX-270 (manufactured by JEOL Ltd.) using a deuterated chloroform solution.

### Synthetic Example 1

### Synthesis of Intermediate 1

Compound 1 (0.48 g) and vinylene carbonate (0.1 mL) were heated to reflux in ortho-dichlorobenzene (10 mL) for 15 hours. The resulting reaction liquid was cooled to room temperature, a large excess of hexane was added thereto and vigorously stirred so that a powdery solid was produced. The powdery solid was collected by filtration and dried to obtain a white powder as Intermediate 1. Intermediate 1 was a mixture of isomers. Yield: 0.53 g (98%), ¹H-NMR (δ:ppm): 7.93-6.75 (m, 34H), 4.88-4.23 (m, 4H)

### Synthesis of Intermediate 2

Intermediate 1 (0.33 g) was dissolved in 1,4-dioxane (20 mL), and an aqueous sodium hydroxide solution (4N, 7.5 mL) was added thereto under nitrogen atmosphere, and the resulting mixture was heated to reflux for 6 hours. After the completion of reaction, water (50 mL) was added thereto, followed by stirring. Then, dichloromethane (50 mL) was further added thereto, followed by stirring. The organic phase was separated, washed with saturated brine, dried over sodium sulfate, and filtered. The resulting filtrate was concentrated to driness to obtain a white solid as Intermediate 2. Intermediate 2 was a mixture of isomers. Yield: 0.32 g (99%), ¹H-NMR (δ:ppm): 7.91-6.94 (m, 34H), 4.41-3.97 (m, 4H)

### Synthesis of Compound 2

Dimethyl sulfoxide (1.2 mL) was dissolved in dehydrated dichloromethane (10 mL) and cooled to -78°C. Then, trifluoroacetic anhydride (2. 1 mL) was added dropwise, followed by stirring at -78°C for 15 minutes to obtain a mixture. A dehydrated dichloromethane solution (10 mL) of Intermediate 2 (0.25 g) was slowly added to the mixture, followed by stirring at -78°C for 90 minutes. Then, triethylamine (2.5 mL) was added thereinto, followed by stirring at -78°C for 90 minutes. Then, the resulting reaction liquid was heated to room temperature. After the completion of reaction, dichlromethane was added thereto, followed by stirring, and the organic phase was washed with water. The organic phase was separated, dried with sodium sulfate, and filtered. The resulting filtrate was concentrated and dried to obtain a solid. The solid was purified by silica gel chromatography to obtain a yellow powder as Compound 2. Yield: 0.08 g (32%), ¹H-NMR (δ:ppm): 7.87-6.95 (m, 34H), 4.94 (s, 2H)

In the case of Compound 1, a solution having a concentration of 0.5 wt% or higher could not be prepared by using any one of dichlorobenzene, chloroform, tetralin, ethyl benzoate, and N-methyl-2-pyrrolidone as a solvent. On the other hand, in the case of Compound 2, a solution having a concentration of 2 wt% or higher could be prepared by using any one of dichlorobenzene, chloroform, tetralin, ethyl benzoate, and N-methyl-2-pyrrolidone as a solvent.

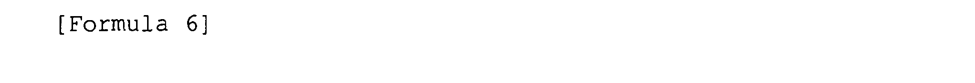

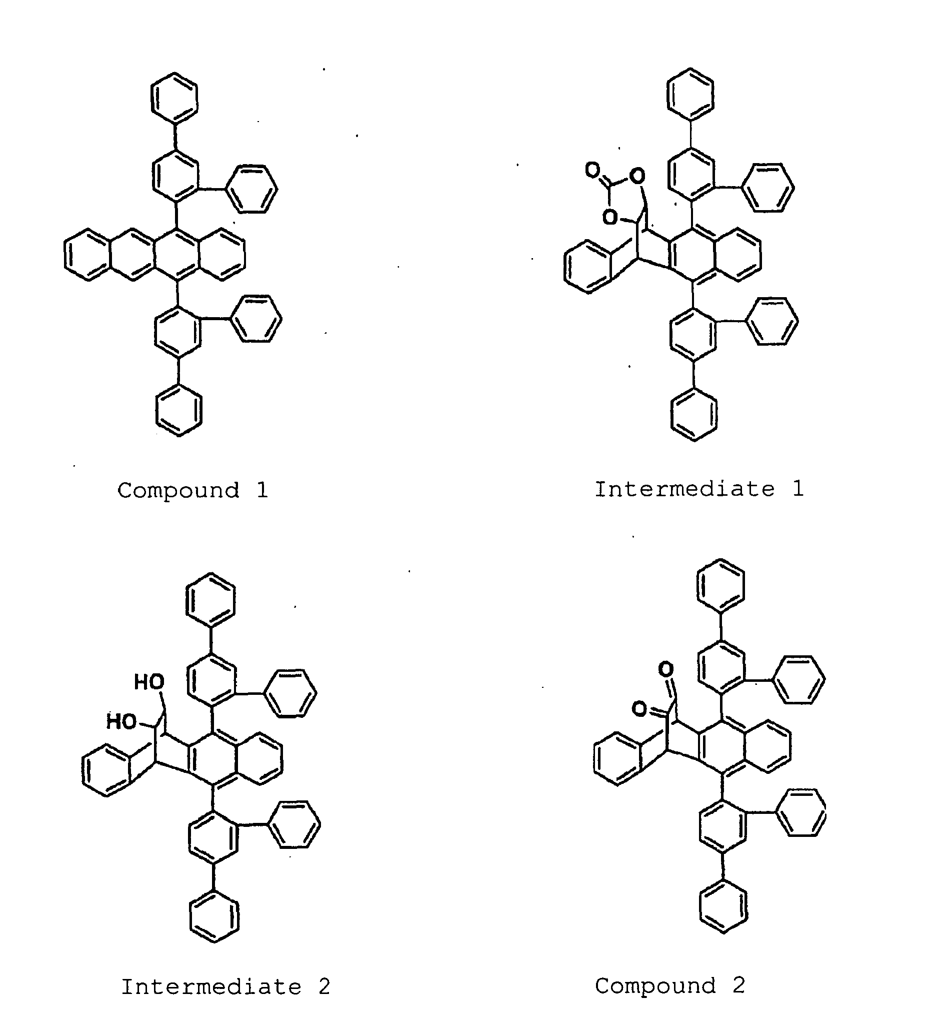

### Synthetic Example 2

### Synthesis of Intermediate 3

Compound 3 (0.53 g) and vinylene carbonate (0.1 mL) were heated to reflux in ortho-dichlorobenzene (10 mL) for 15 hours. The resulting reaction liquid was cooled to room temperature, a large excess of hexane was added thereto and vigorously stirred so that a powdery solid was produced. The powdery solid was collected by filtration and dried to obtain as Intermediate 3. Intermediate 3 was a mixture of isomers. Yield: 0.56 g (99%), ¹H-NMR (δ:ppm): 8.03-7.01 (m, 20H), 4.89-4.45 (m, 4H)

### Synthesis of Intermediate 4

Intermediate 3 (0.50 g) was dissolved in 1,4-dioxane (30 mL), and an aqueous sodium hydroxide solution (4N, 10 mL) was added thereto under nitrogen atmosphere and the resulting mixture was heated to reflux for 6 hours. After the completion of reaction, water (50 mL) was added thereto, followed by stirring. Then, dichloromethane (50 mL) was further added thereto, followed by stirring. The organic phase was separated, washed with saturated brine, dried with sodium sulfate, and filtered. The resulting filtrate was concentrated to driness to obtain a white solid as Intermediate 4. Intermediate 4 was a mixture of isomers. Yield: 0.47 g (81%), ¹H-NMR (δ:ppm): 8.00-6.98 (m, 20H), 4.39-4.23 (m, 4H)

### Synthesis of Compound 4

Dimethyl sulfoxide (2.0 mL) was dissolved in dehydrated dichloromethane (20 mL) and cooled to -78°C. Then, trifluoroacetic anhydride (4.0 mL) was added dropwise, followed by stirring at -78°C for 15 minutes to obtain a mixture. A dehydrated dichloromethane solution (10 mL) of Intermediate 4 (0.25 g) was slowly added to the mixture, followed by stirring at -78°C for 90 minutes. Then, triethylamine (10 mL) was added thereinto, followed by stirring at -78°C for 90 minutes. Then, the resulting reaction liquid was heated to room temperature. After the completion of reaction, dichlromethane was added thereto, followed by stirring, and the organic phase was washed with water. The organic phase was separated, dried with sodium sulfate, and filtered. The resulting filtrate was concentrated and dried to obtain a solid. The solid was purified by silica gel chromatography to obtain a yellow powder as Compound 4. Yield: 0.08 g (32%), ¹H-NMR (δ:ppm): 8.05-7.09 (m, 20H), 4.77 (s, 2H)

In the case of Compound 3, a solution having a concentration of 0. 5 wt% or higher could not be prepared by using any one of dichlorobenzene, chloroform, tetralin, ethyl benzoate, and N-methyl-2-pyrrolidone as a solvent. On the other hand, in the case of Compound 4, a solution having a concentration of 2 wt% or higher could be prepared by using any one of dichlorobenzene, chloroform, tetralin, ethyl benzoate, and N-methyl-2-pyrrolidone as a solvent.

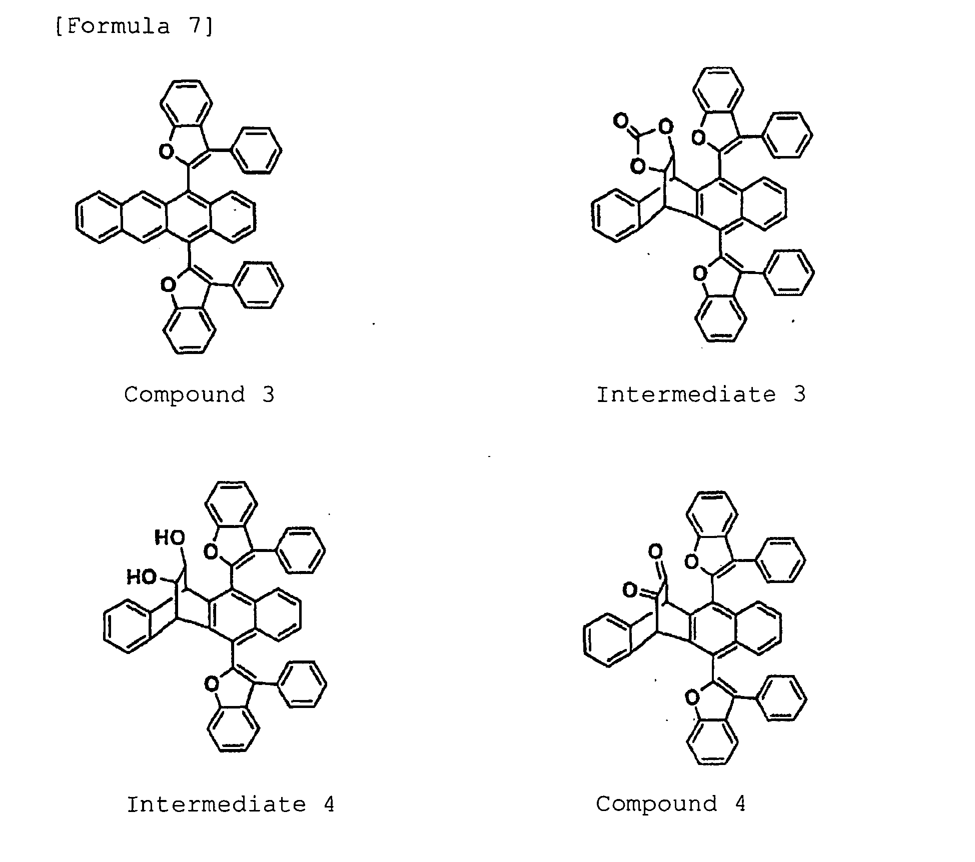

### Example 1

A donor substrate was prepared in the following manner. An alkali-free glass substrate prepared as a support was washed and treated in a UV-ozone chamber. Then, a titanium film of 1.0 µm in thickness was formed by sputtering as a light-to-heat conversion layer on the entire surface of the support. the light-to-heat conversion layer was treated in a UV-ozone chamber, and then, a positive-type polyimide-based photosensitive coating agent ("DL-1000" manufactured by Toray Industries, INC.) was applied onto the light-to-heat conversion layer by spin-coating, pre-baked, and exposed to UV light. Then, the UV-exposed areas were dissolved in a developer ("ELM-D" manufactured by Toray Industries, INC.) and removed to obtain a patterned polyimide precursor film. The polyimide precursor film was baked using a hot plate at 350°C for 10 minutes to form a polyimide-based division pattern. The division pattern had a height of 2 µm and a forward-tapered cross-sectional shape. In the division pattern, openings each having a width of 80 µm and a length of 280 µm were arranged at a pitch of 100 µm in a width direction and a pitch of 300 µm in a length direction, and the light-to-heat conversion layer was exposed through the openings. This substrate was spin-coated with a chloroform solution containing Compound 2 in an amount of 3 wt% and DCJTB represented by the following formula in an amount of 0.15 wt% and dried. The resulting thin film was irradiated with light, which was emitted from a high-pressure mercury lamp (600 W) and passed through a blue filter (peak wavelength: 405 nm (half-width: 5 nm), 436 nm (half-width: 5 nm)), under a nitrogen atmosphere for 3 hours to convert Compound 2 to Compound 1. As a result, a layer made of Compound 1 and DCJTB and having an average thickness of 25 nm was formed in the division pattern (openings).

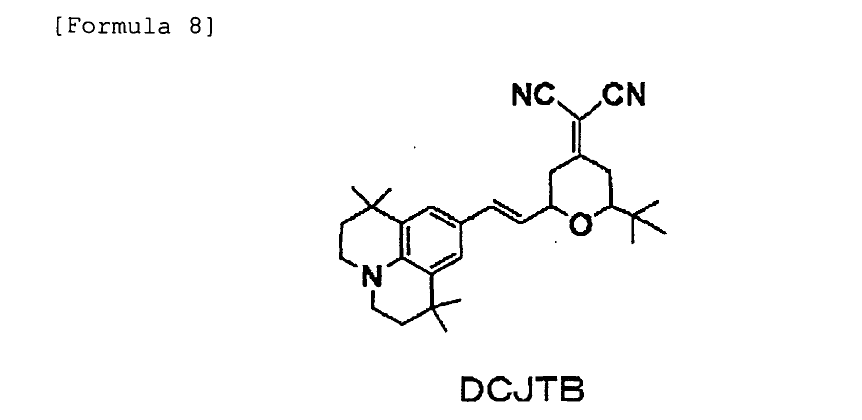

A device substrate was formed in the following manner. An alkali-free glass substrate having a 140 nm-thick ITO transparent conductive film deposited thereon (a glass substrate with sputtered film manufactured by GEOMATECH Corporation) was cut into pieces having a size of 38 × 46 mm, and the ITO film was etched to a shape shown in Fig. 7 by photolithography. Then, a patterned polyimide precursor film was formed in the same manner as in the case of the donor substrate, and baked at 300°C for 10 minutes to form a polyimide-based insulating layer. The insulating layer had a height of 1.8 µm and a forward-tapered cross-sectional shape. In the patterned insulating layer, openings each having a width of 70 µm and a length of 270 µm were arranged at a pitch of 100 µm in a width direction and a pitch of 300 µm in a length direction, and the ITO was exposed through the openings. This substrate was treated in a UV-ozone chamber, and was then placed in a vacuum deposition apparatus, and the apparatus was evacuated to a degree of vacuum of 3 × 10⁻⁴ Pa or less. A hole-transporting layer comprising a laminate of a 20 nm-thick copper phthalocyanine (CuPc) layer and a 40 nm-thick NPD layer was formed by resistance-heating vapor deposition over the entire light-emitting region.

Then, the donor substrate and the device substrate were opposed to each other so that the division pattern of the donor substrate and the insulating layer of the device substrate were aligned with each other, and were placed in a vacuum of 3 × 10⁻⁴ Pa or less and then exposed to the atmosphere. A transfer space defined by the insulating layer and the division pattern was maintained under vacuum. In this state, the donor substrate was irradiated with laser light having a center wavelength of 800 nm (light source: semiconductor laser diode) from the glass substrate side so that a part of the material present in the division pattern and a part of the division pattern were simultaneously heated to transfer the material present in the division pattern onto the hole-transporting layer provided as an underlayer of the device substrate. The laser light had an intensity of about 300 W/mm², and a scanning speed was 1.25 m/s. Scanning was repeatedly performed by a method, in which adjacent laser-irradiated areas overlap with each other, so that the material present in the division pattern was transferred onto the entire light-emitting region.

After the completion of transfer, the device substrate was again placed in the vacuum deposition apparatus, and the apparatus was evacuated to a degree of vacuum of 3 × 10⁻⁴ Pa or less. E-1 shown below was vapor-deposited to a thickness of 25 nm as an electron-transporting layer over the entire light-emitting region. Then, lithium fluoride was vapor-deposited to a thickness of 0.5 nm as a donor material (electron-injection layer), and then aluminum was further vapor-deposited to a thickness of 100 nm as a second electrode. In this way, an organic EL device having a light-emitting region of 5 mm square was produced.

### Example 2

An organic EL device was produced in the same manner as in Example 1 except that DCJTB was changed to Compound 5 represented by the following formula.

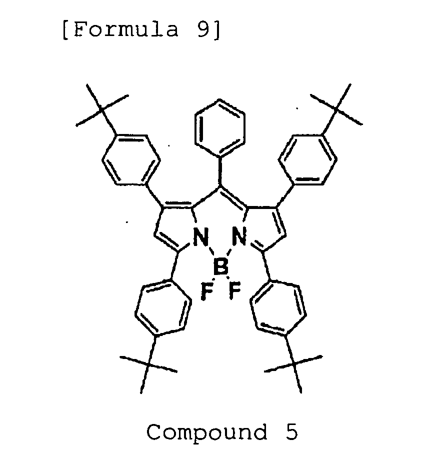

### Example 3

An organic EL device was produced in the same manner as in Example 2 except that the hole-transporting layer comprising a laminate of a copper phthalocyanine layer and a NPD layer formed by vacuum deposition was changed to one formed by spin-coating a film of an aqueous PEDOT
(poly(3,4-ethylenedioxythiophene) :PSS
(poly(4-styrenesulfonate) solution (PEDOT: 0.8 wt%, PSS: 0.5 wt%) to a thickness of 100 nm and drying the film by heating using a hot plate at 200°C for 5 minutes.

### Comparative Example 1

An organic EL device was produced in the same manner as in Example 1 except that the film formed on the donor substrate by applying a chloroform solution containing Compound 2 and DCJTB was changed to one formed by applying a chloroform suspension containing Compound 1 and DCJTB without performing light irradiation. A chloroform solution containing Compound 1 in an amount of 3 wt% could not be prepared due to a low solubility of Compound 1, and therefore a chloroform suspension was used. In this case, the material layer formed on the donor substrate had a nonuniform thickness, and a satisfactory transferred layer could not be obtained. Further, Compound 1 was deposited on the device substrate by transfer, but the resulting film was of poor quality. Therefore, electroluminescent emission from Compound 1 and DCJTB was not observed in the organic EL device produced.

### Comparative Example 2

An organic EL device was produced in the same manner as in Example 3 except that the emissive layer formed by transferring a luminescence material layer formed on the donor substrate onto the device substrate was changed to one formed by applying a chloroform solution containing Compound 2 in an amount of 3 wt% and DCJTB in an amount of 0.15 wt% directly onto the device substrate by spin coating, drying the solution to form a film, and irradiating the film with light, which was emitted from a high-pressure mercury lamp (600 W) and passed through a blue filter (peak wavelength: 405 nm (half-width: 5 nm), 436 nm (half-width: 5 nm)), in a nitrogen atmosphere for 3 hours to convert Compound 2 to Compound 1.

### Comparative Example 3

An organic EL device was produced in the same manner as in Example 1 except that the emissive layer formed by transferring a luminescence material layer formed on the donor substrate onto the device substrate was changed to one formed by applying a chloroform solution containing Compound 2 in an amount of 3 wt% and DCJTB in an amount of 0.15 wt% directly onto the device substrate by spin coating, drying the solution to form a film, and irradiating the film with light, which was emitted from a high-pressure mercury lamp (600 W) and passed through a blue filter (peak wavelength: 405 nm (half-width: 5 nm), 436 nm (half-width: 5 nm)), under a nitrogen atmosphere for 3 hours.

### Comparative Example 4

An organic EL device was produced in the same manner as in Example 1 except that the donor substrate having a thin film made of Compound 2 and DCJTB was directly irradiated with light emitted from a high-pressure mercury lamp (600 W) (including light within a wavelength range of 390 nm or less) without allowing the light to pass through a blue filter. In this case, an undesired reaction occurred, and therefore Compound 2 was not converted to Compound 1 and electroluminescent emission from DCJTB was not observed.

### Example 4

A donor substrate was prepared in the same manner as in Example 1 except that a 0.4 µm-thick molybdenum film was formed by sputtering as the light-to-heat conversion layer on its entire surface and that a thin film made of Compound 4 and DCJTB was formed on the donor substrate. Then, the conversion step was performed in the same manner as in Example 1 except that the thin film was irradiated with light emitted from a blue light-emitting diode (center wavelength: 460 nm, half-width: 20 nm) for 5 minutes instead of light emitted from a high-pressure mercury lamp and passed through a blue filter. As a result, a layer made of Compound 3 and DCJTB and having an average thickness of 25 nm was formed in the division pattern (openings). Further, an organic EL device was produced in the same manner as in Example 1 except that scanning was performed using, instead of laser light having a center wavelength of 800 nm) (light source: semiconductor laser diode), light having a center wavelength of 940 nm and formed into a rectangular shape to irradiate an area having a width of 340 µm and a length of 50 µm (light source; semiconductor laser diode) under conditions where a scanning speed was 0.6 m/s, the number of times of transfer was 24, and the intensity of laser light was 148 W/mm².

### Example 5

An organic EL device was produced in the same manner as in Example 4 except that DCJTB was changed to Compound 5.

### Example 6

An organic EL device was produced in the same manner as in Example 4 except that the hole-transporting layer was changed from a laminate of a copper phthalocyanine layer and a NPD layer formed by vacuum deposition to a film formed by spin-coating an aqueous PEDOT:PSS solution (PEDOT: 0.8 wt%, PSS: 0.5 wt%) to a thickness of 100 nm and drying the solution by heating using a hot plate at 200°C for 5 minutes.

### Example 7

A tetralin solution containing 1 wt% of Compound 2 and 0.05 wt% of Compound 5 was prepared. Then, the tetralin solution was applied onto a donor substrate by ink-jet printing and dried to form a film of a mixture of Compound 2 and Compound 5 in the division pattern. The film of a mixture of Compound 2 and Compound 5 was irradiated with light emitted from a blue light-emitting diode (center wavelength: 460 m, half-width: 20 nm) in a vacuum for 5 minutes to convert Compound 2 to Compound 1.

An organic EL device was produced in the same manner as in Example 4 except that a film made of a mixture of Compound 1 and Compound 5 was formed in the division pattern of the donor substrate in such a manner as described above as a transferring material layer having an average thickness of 40 nm.

### Comparative Example 5

An organic EL device was produced in the same manner as in Example 4 except that the chloroform solution containing Compound 4 and DCJTB was changed to a chloroform suspension containing Compound 3 and DCJTB. In this case, the material layer formed on the donor substrate had a nonuniform thickness, and a satisfactory transferred layer could not be obtained. Further, Compound 3 was deposited on the device substrate by transfer, but the resulting film was of poor quality, and therefore electroluminescent emission from Compound 4 and DCJTB was not observed in the organic EL device produced.

### Comparative Example 6

An organic EL device was produced in the same manner as in Comparative Example 2 except that Compound 2 was changed to Compound 4 and light irradiation was performed for 5 minutes using light emitted from a blue light-emitting diode (center wavelength: 460 nm, half-width: 20 nm) instead of light emitted from a high-pressure mercury lamp and passed through a blue filter.

### Comparative Example 7

An organic EL device was produced in the same manner as in Comparative Example 3 except that Compound 2 was changed to Compound 4 and light irradiation was performed for 5 minutes using light emitted from a blue light-emitting diode (center wavelength: 460 nm, half-width: 20 nm) instead of light emitted from a high-pressure mercury lamp and passed through a blue filter.

### Comparative Example 8

An organic EL device was produced in the same manner as in Comparative Example 4 except that Compound 2 was changed to Compound 4. In this case, Compound 4 could not be converted to Compound 3, and electroluminescent emission from DCJTB was not observed.

These organic EL devices produced in Examples 1 to 6 and Comparative Examples 1 to 8 were sealed, and then a constant current of 2.5 mA/cm² was applied to each of the organic EL devices. Just after the application of current, the luminance of light was measured and defined as initial luminance. The initial luminance efficiency of each of the organic EL devices was determined by dividing the initial luminance by a current density. Further, the length of time before the luminance was reduced to half the initial luminance was measured under constant current conditions and was defined as half-life of luminance. The measurement values of initial luminance efficiency and half-life of luminance of the organic EL device of Example 1 were defined as 1.0 to determine the relative initial luminance efficiency and relative half-life of luminance of each of the organic EL devices of Examples 2 and 3 and Comparative Examples 1 to 4. The measurement results are shown in Table 1. Further, the measurement values of initial luminance efficiency and half-life of luminance of the organic EL device of Example 4 were defined as 1.0 to determine the relative initial luminance efficiency and relative half-life of luminance of each of the organic EL devices of Examples 5 and 6 and Comparative Examples 5 to 8. The measurement results are shown in Table 2.

**[Table 1]**

| | Example 1 | Example 2 | Example 3 | Comparative Example 1 | Comparative Example 2 | Comparative Example 3 | Comparative Example 4 |
|---|---|---|---|---|---|---|---|
| rerative initial luminance efficiency | 1.0 | 1.2 | 1.1 | no red emission | 0.6 | 0.1 | no red emission |
| relative half-life of luminance | 1.0 | 1.1 | 1.0 | no red emission | 0.6 | 0.1 | no red emission |

**[Table 2]**

| | Example 4 | Example 5 | Example 6 | Comparative Example 5 | Comparative Example 6 | Comparative Example 7 | Comparative Example 8 |
|---|---|---|---|---|---|---|---|
| rerative initial luminance efficiency | 1.0 | 1.4 | 1.0 | no red emission | 0.3 | 0.2 | no red emission |
| relative half-life of luminance | 1.0 | 1.3 | 1.0 | no red emission | 0.2 | 0.2 | no red emission |

As can be seen from Comparative Examples 1 and 5, Compound 1 and Compound 3 are materials difficult to form a film by application. However, as can be seen from Examples 1 to 6, it becomes possible to produce a device using Compound 1 or Compound 3 by an application method by forming a film of a precursor material of Compound 1 or Compound 3, which can be formed into a film by application, onto a donor substrate, converting the precursor material to a device-constituting material, and transferring the device-constituting material. Further, as can be seen from the comparison between Examples 1 and 3 and Comparative Examples 2, 3, 6, and 7, a device produced by converting a precursor material applied onto a donor substrate to a device-constituting material and transferring the device-constituting material onto a device substrate can have significantly improved characteristics as compared to a device produced simply by applying a precursor material directly onto a device substrate and converting the precursor material to a device-constituting material.

The conversion from Compound 2 to Compound 1 and the conversion from Compound 4 to Compound 3 are effectively carried out by irradiation with light having a peak wavelength of 430 to 470 nm and a peak half-width of 50 nm or less.

### INDUSTRIAL APPLICABILITY

The present invention relates to a technique for patterning thin films constituting devices such as organic EL devices, OTFTs, photoelectric conversion devices, and various sensors, and can be applied to the production of display panels, touch panels, and image-pickup devices for use in, for example, mobile phones, personal computers, television sets, and image scanners.

### DESCRIPTION OF REFERENCE NUMERALS

- 10: organic EL device (device substrate)
- 11: support
- 12: TFT (including a lead electrode)
- 13: planarizing layer
- 14: insulating layer
- 15: first electrode
- 16: hole-transporting layer
- 17: emissive layer
- 18: electron-transporting layer
- 19: second electrode
- 20: device substrate
- 22: support
- 27: transferred layer
- 30: donor substrate
- 31: support
- 33: light-to-heat conversion layer
- 34: division pattern
- 37: device-constituting material
- 38: transfer region
- 40: glass substrate
- 41: ITO pattern

## Claims

1. A method for producing a device comprising the steps of:
applying, on a donor substrate, a precursor material which is solvent-soluble during application and is capable of being converted to a device-constituting material after the application;
converting the precursor material to a device-constituting material; and
transferring the material on the donor substrate onto a device substrate.

2. The method for producing a device according to claim 1, wherein the conversion step is carried out before the transfer step.

3. The method for producing a device according to claim 1, wherein the conversion step is carried out simultaneously with the transfer step.

4. The method for producing a device according to any one of claims 1 to 3, wherein the conversion is carried out by light irradiation and/or heat treatment.

5. The method for producing a device according to any one of claims 1 to 4, wherein the conversion is carried out by irradiation of light having a peak wavelength of 430 to 470 nm and a peak half-width of 50 nm or less.

6. The method for producing a device according to any one of claims 1 to 5, wherein the transfer step is carried out by laser transfer.

7. The method for producing a device according to any one of claims 1 to 6, wherein the precursor material has a keto-bridged structure and/or a diketo-bridged structure and is converted to a device-constituting material with generation of carbon monoxide.

8. The method for producing a device according to any one of claims 1 to 7, wherein the device-constituting material has a naphthacene skeleton, a pentacene skeleton, or an anthrylpyrene skeleton.

9. The method for producing a device according to any one of claims 1 to 8, wherein the device is a light-emitting device and the device-constituting material is a light-emitting device material. 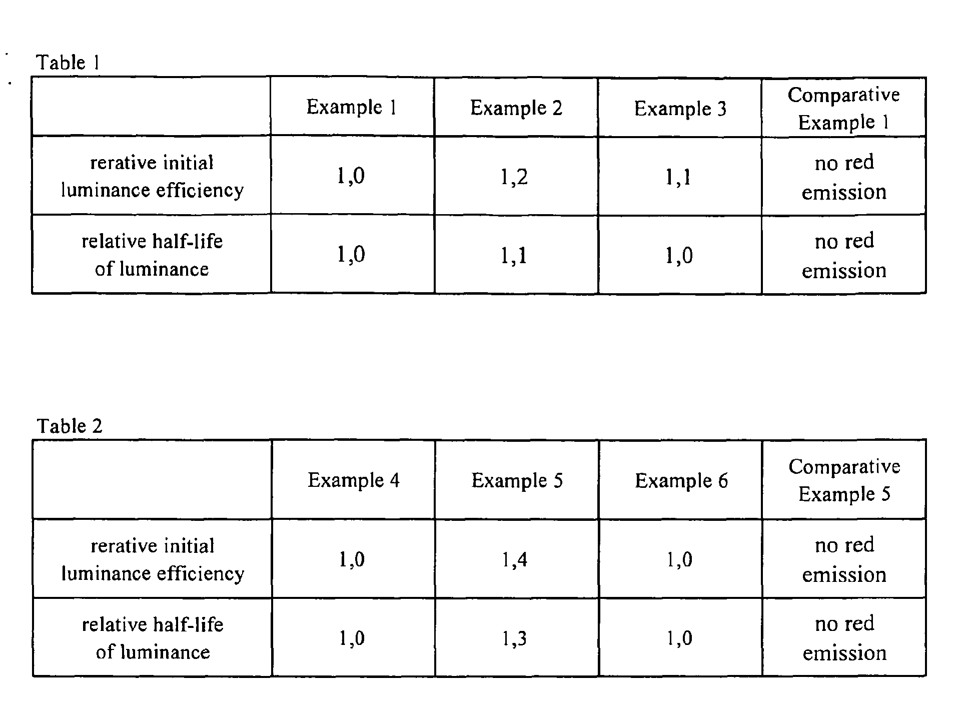
| Comparative Example 2 | Comparative Example 3 | Comparative Example 4 |
|---|---|---|
| 0,6 | 0,1 | no red emission |
| 0,6 | 0,1 | no red emission |
| | | |
| Comparative Example 6 | Comparative Example 7 | Comparative Example 8 |
|---|---|---|
| 0,3 | 0,2 | no red emission |
| 0,2 | 0,2 | no red emission |
